# EUROPEAN PATENT APPLICATION

(11) **EP 3 364 455 A1**
(43) Date of publication of application: **22.08.2018**
(21) Application number: 17156474.3
(22) Date of filing: 16.02.2017
(51) Int. Cl.: H01L 23/498, H05K 1/02

(54) **SWIRL INTERCONNECTION IN A FLEXIBLE CIRCUIT**

(71) Applicant: Nederlandse Organisatie voor toegepast- natuurwetenschappelijk onderzoek TNO, 2595 DA 's-Gravenhage (NL)
(72) Inventor: VAN HECK, Gerardus, 2595 DA 's-Gravenhage (NL); BARINK, Marco, 2595 DA 's-Gravenhage (NL); DE KOK, Margaretha Maria, 2595 DA 's-Gravenhage (NL)
(74) Representative: V.O.

(57) **Abstract**

The present disclosure concerns a flexible electronic circuit (100) and method of manufacturing. A flexible substrate (30) with conductive tracks is provided with a rigid electronic component (10). The component (10) comprises electrical contacts (11,12) on either sides. The conductive tracks connect to the contacts via an arced section that originates from respective sides of the contacts but swirls partially around the component to approaches the component along a centerline (CL) separating the contacts (11,12).

## Description

### TECHNICAL FIELD AND BACKGROUND

The present disclosure relates to a flexible electronic circuit and a method for manufacturing same.

Extreme mechanical impact such as during thermoforming of electronics of washable electronics leads to challenges of the interconnects between rigid components and more flexible and stretchable (e.g. printed) structures. To alleviate some problems, a gradual transition in rigidity between the rigid parts and the stretchable structures and/or specific fortification of the materials near the interconnection may be provided. This may enhance for example the washability and thermo-formability of electronics by preventing small bending radii. Another possibility is the positioning of vulnerable interconnects at or near the neutral line of a design.

There remains a desire to improve damage resistance of interconnects in flexible electronic circuits when the circuit is subjected to bending, stretching and/or twisting forces.

### SUMMARY

To this end, a first aspect of the present disclosure is directed to a flexible electronic circuit. The circuit comprises a substrate such as a flexible foil. The circuit comprises at least one (rigid) electronic component disposed on the substrate. The component comprises a first electrical contact on a first side thereof and a second electrical contact on an opposite second side. Conductive tracks disposed on the substrate comprise a first conductive track formed along a first pathway. The first pathway runs between a first contact pad contacting one of the electrical contacts and a first main connection to the rest of the conductive tracks. The first main connection is disposed in a direction of the first side of the electronic component. A second conductive track is formed along a second pathway. The second pathway runs between a second contact pad contacting the other one of the electrical contacts of the electronic component and a second main connection to the rest of the conductive tracks. The second main connection is disposed at the second side, i.e. on the opposite side of the electronic component with respect to the first main connection. In other words, the component is between the main connections with the first and second sides of the component respectively facing the first and second main connections.

Advantageously, the first pathway comprises a first arced section that approaches the electronic component from a third side along a center line of the electronic component. The center line intersects the electronic component at the third side of the electronic component transverse to the first side and the second side of the electronic component. Furthermore, the said centerline is between, i.e. divides the first electrical contact from the second electrical contact. Similarly, the second pathway comprises a second arced section that approaches the electronic component along the center line of the electronic component but from a fourth side of the electronic component, opposite the third side.

By providing an arced or curved connection that connects with the component from the middle thereof between the electrical contact, the connection is found to be more robust. For example, when the substrate is bent, this may put less immediate strain on the connection with the electrical contacts because the connection approaches the contact from a direction of the centerline, instead of from the outside. Furthermore, the arced or curved section follows a path with different angles to allow the substrate to be more easily bent at a place where the path is transverse to the bending direction. Furthermore, the arced section may be more tolerant to a local twisting of the substrate by uncoiling. Accordingly, damage resistance of the electronic circuits may be improved when subjected to bending, stretching and/or twisting forces.

By providing an arced section that extends over a semicircular or semielliptical path, the path may follow different angles along relatively short path e.g. compared to an undulating path. Accordingly, it may be preferable that the path is curved to rotate in one direction. By providing the path with a changing direction such that the arc length corresponding to a change of angle of at least ninety degrees, this may allow easy bending in multiple directions transverse to the path. To further improve e.g. twisting and/or stretching tolerance longer arc lengths can be used, e.g. more than ninety, hundred, hundred-ten, or hundred-twenty degrees, preferably between ninety and two-hundred-seventy degrees plane angle.

By providing arced sections that swirl or swing at least partially around the electronic component improved tolerance to a variety of mechanical forces may be provided. By keeping the forces away from the edges the component, it may be prevented that the connection gets damaged by peeling of the flexible substrate from the rigid component. By providing the arced path such that any folds transverse to the path stay clear of the component or at least the connection to the electrical contacts, damage may be further alleviated. By providing the arced sections to be rotation symmetric with respect to each other, the component may withstand some twisting while equally distributing the strain over both connections.

Displacing the connections of the electrical contacts such that each main connection on one side of the component connects to the contact on the other side of the component may have several advantages. For example, the arced section may require less curvature at the end to connect to the corresponding contact. Furthermore, in some cases the layout of the arced sections may be more compact. By having the arced section transition into a buried section below the component, the connection may approach the respective contact from the center line to improve the robustness of the connection. In particular, by avoiding connection points between the component and tracks at the corners of the component, a typical point of failure while bending may be alleviated.

By providing the curved section with relatively small track with compared to the rest of the circuit, in particular the main connection, the curved section may be more flexible. At the same time, electrical resistance can be minimized by the relatively wide main section, e.g. acting as a busbar. Accordingly, it may be desired in some cases that a minimum track width of the main connection is wider than that of the arced section by at least a factor two, or more, e.g. between three and five times wider (e.g. transverse to the track length or electrical path). To avoid sudden transition between the curved section and the main connection, these may be interconnected by tear drop sections that widen from the respective arced section towards the respective main connection.

While the present teaching may provide advantage to any shape component, it is recognized that additional benefit may be achieved when the component has a length greater than its width and the curved section approaches the component from the long side. In that case, the stress between the flexible substrate and rigid component may have less impact at the point of connection. Accordingly, additional benefit may be provided for circuits wherein a length of the electronic component is greater than its width, e.g. by a factor of at least one and half, at least two, or more. For example, the electronic component may typically have a rectangular shape.

Further advantages may be provided when the substrate is excised or cut to form openings at least around each of the arced sections and/or component. By forming such openings, the curved sections and/or the component may be more free to move with less localized stress on the substrate. The most effect may be achieved by providing the openings close to the outer edges of the arced sections, e.g. with a margin of substrate without conducting track being less than fifty percent of the respective track width of the arced section, preferably less, e.g. less than twenty percent, ten percent, or even wherein there is no margin and the openings are directly adjacent the conducting tracks of the arced sections on top of arced sections of the substrate underneath.

To improve robustness while maintaining flexibility, the circuit may be encapsulated by a flexible and/or stretchable layer after manufacturing. By providing a layer that is also water protective, the circuit can be made more suitable for various applications, e.g. integrated into a clothing article. For example, the electronic circuit may continue to function during or after it is in contact with water, or even submerged in water as may happen in a washing machine. By providing a water protective layer with a top layer and a bottom layer the circuit can be easily encapsulated from either side. For example, the protective layer may comprise a thermoplastic material such as thermoplastic polyurethane (TPU). Besides clothing, also other applications may be envisaged for the circuit as described herein. For example, a non-planar object may be provided with a curved interface comprising the electronic circuit, e.g. molded by thermoforming.

Further aspects of the present disclosure may be related to a method of manufacturing the flexible electronic circuit. The method may comprise providing a substrate, depositing conductive tracks onto the substrate, and placing an electronic component onto the conductive tracks, as described herein. The method may also comprise other steps, e.g. cutting openings in the substrate to disconnect the arced sections of the conductive tracks from the surrounding substrate. In some embodiments, the circuit with or without cuttings is encapsulated, e.g. by a thermoplastic layer. The circuit may also be integrated into another article, e.g. clothing.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1 schematically illustrates a plan view of an embodiment of a flexible electronic circuit focused around the electronic component;
FIGs 2A and 2B schematically illustrate side views of steps for adhering the electronic circuit to a fabric;
FIG 3 schematically illustrates a plan view of an embodiment of a flexible electronic circuit comprising multiple electronic components;
FIGs 4A and 4B show a comparison of placing the electronic component onto the substrate along different directions;
FIGs 5A and 5B shows perspective views of a comparative study with simulations of stress forces in a substrate without and with incisions;
FIG 6 shows an enlarged photograph of an embodiment of the electronic circuit.

### DESCRIPTION OF EMBODIMENTS

The invention is described more fully hereinafter with reference to the accompanying drawings, in which embodiments of the invention are shown. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise.

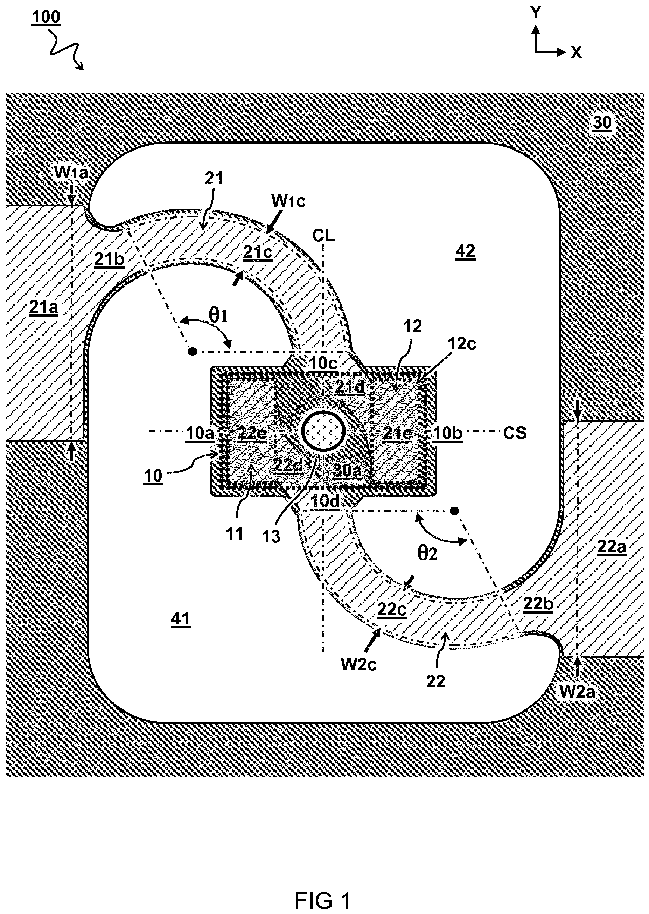

FIG 1 schematically illustrates a plan view of an embodiment of a flexible electronic circuit 100.

In the embodiment shown, the circuit 100 comprises a substrate 30 with an electronic component 10. Furthermore, conductive tracks 20 are disposed on top of the substrate 30. In some embodiments, the electronic component 10 comprises a first electrical contact 11 on a first side 10a of the electronic component 10, and a second electrical contact 12 on a second side 10b of the electronic component 10 opposite the first side 10a.

In one embodiment, the conductive tracks 20 comprise a first conductive track 21 formed along a first pathway 21a-e between a first contact pad 21e contacting one of the electrical contacts 11,12 of the electronic component 10 and a first main connection 21a to the rest of the conductive tracks 20 disposed at the first side 10a of the electronic component 10. In another or further embodiment, a second conductive track 22 is formed along a second pathway 22a-e between a second contact pad 22e contacting the other one of the electrical contacts 11,12 of the electronic component 10 and a second main connection 22a to the rest of the conductive tracks 20 disposed at the second side 10b of the electronic component 10.

In a preferred embodiment, the first pathway 21a-e comprises a first arced section 21c that approaches the electronic component 10 from a third side 10c along a center line CL of the electronic component 10. The center line CL intersects the electronic component 10 at the third side 10c of the electronic component 10 transverse to the first side 10a and the second side 10b of the electronic component 10 and between the electrical contacts 11,12. Furthermore, the second pathway 22a-e comprises a second arced section 22c that approaches the electronic component 10 along the center line CL of the electronic component 10 from a fourth side 10d of the electronic component 10 opposite the third side 10c.

In one embodiment, the arced sections 21c,22c respectively extend over a semicircular or semielliptical path between the electrical contact 11,12 of the electronic component 10 and the main connection 21a,22a to the electronic circuit 100, wherein the direction along a respective arced section 21c,22c along an arc length corresponding to a change of angle θ1,θ2 of more than ninety degrees, e.g. at least hundred, hundred-ten, or hundred-twenty degrees, preferably between ninety and two hundred seventy degrees plane angle. In some embodiments, the arced sections 21c,22c swirl or swing at least partially around the electronic component 10. Preferably, a shape of the first arced section 21c is rotation symmetric to a shape of the second arced section 22c.

In one embodiment, the first conductive track 21 starting from the first main connection 21a disposed at the first side 10a of the electronic component 10 connects to the second electrical contact 12 disposed at the second side 10b opposite the first side 10a. In another or further embodiment,, the second conductive track 22 starting from the second main connection 22a disposed at the second side 10b of the electronic component 10 connects to the first electrical contact 11 disposed at the first side 10a opposite the second side 10b.

In one embodiment, the first arced section 21c of the first conductive track 21 approaching the electronic component 10 from the third side 10c transitions into a first buried section 21d that starts from the center line CL and proceeds between the electronic component 10 and a part 30a of the substrate 30 below the electronic component 10 to connect to the first contact pad 21e from a direction of the center line CL. In another or further embodiment, the second arced section 22c of the second conductive track 22 approaching the electronic component 10 from the fourth side 10d transitions into a second buried section 22d that starts from the center line CL and proceeds between the electronic component 10 and the part 30a of the substrate 30 below the electronic component 10 to connect to the second contact pad 22e from a direction of the center line CL, but from an opposite side of the CL than the first buried section 21d.

In one embodiment, a minimum track width W1a,W2a of the respective main connection 21a,22a is wider than a minimum track width W1c,W2c of the respective arced section 21c,22c e.g. by at least a factor two, or more, e.g. between three and five times wider. In another or further embodiment, the arced sections 21c,22c are connected to the respective main connections 21a,22a by respective a tear drop sections 21b,22b that widen from the respective arced section 21c,22c towards the respective main connection 21a,22a. For example, the first and second main connections 21a,22b are respective busbars of the conductive tracks 20 with a relatively wide minimum track width W1a,W2a compared to a respective track width W1c,W2c of the arced sections 21c,22c.

In one embodiment, the electronic component 10 has a length L (not indicated) that is greater along a first direction X in plane of the substrate 30 than its width W (not indicated) along a second direction Y, transverse to the first direction X in plane of the substrate 30. Preferably, the second direction Y is aligned with the center line CL through the third side 10c and fourth side 10d of the electronic component 10 such that the first and second conductive tracks approach the electronic component 10 from its relatively longer third and fourth sides 10c,10d. For example, a length L of the electronic component 10 is greater than its width by a factor of at least one and half, at least two, or more.

In one embodiment, the center line CL is a first center line through the relatively long sides of the electronic component 10, wherein the electrical contacts 11,12 are arranged along another center line CS through the relatively short sides 10a,10b of the electronic component 10. For example, the electronic component 10 has a rectangular shape, wherein the first and second sides 10a,10b form the relatively short sides of the rectangle and the third and fourth sides 10c,10d form the relatively long sides of the rectangle.

In one embodiment, the substrate 30 is excised to form openings 41,42 without the substrate at least around each of the arced sections 21c,22c. Preferably, the openings 41,42 are close to the outer edges of the arced sections 21c,22c, e.g. with a margin of substrate without conducting track being less than fifty percent of the respective track width W1c,W2c of the arced section, preferably less, e.g. less than twenty percent, ten percent, or even wherein there is no margin and the openings 41,42 are directly adjacent the conducting tracks of the arced sections 21c,22c on top of arced sections of the substrate underneath.

In some embodiments, the conductive tracks 21,22 are connected to the electrical contacts 11,12 for powering and/or controlling the electronic component 10 via the conductive tracks 20. For example, the circuit may comprise or be connected to a battery and/or controller (not shown). In one embodiment, the electronic component 10 comprises a light emitting device 13. For example, the circuit may find application in wearable electronics with clothing comprising lights. Accordingly, some aspects of the present disclosure may related to a clothing fabric comprising the electronic circuit 100 as described herein. Further aspects may relate to an article of clothing comprising the electronic circuit 100, wherein the article of clothing further comprises a power source and/or controller for addressing the electrical contacts 11,12. Other applications or aspects may relate to a non-planar object with a curved interface comprising the electronic circuit 100, e.g. molded by thermoforming.

Aspects of the present disclosure may also relate to a corresponding method of manufacturing a flexible electronic circuit 100. Such method may e.g. comprise providing a substrate 30; depositing conductive tracks 20 onto the substrate 30; and placing an electronic component 10 onto the conductive tracks 20, wherein the substrate, component and track may be provides as described herein with reference to the circuit. In some embodiments, the method further comprises cutting openings 41,42 in the substrate 30 to disconnect the arced sections 21c,22c of the conductive tracks 20 from the surrounding substrate 3. In other or further embodiments, the electronic component 10 is substantially only connected to the surrounding substrate 30 via the conductive tracks (and the substrate beneath) of the arced sections 21c,22c.

As used herein, the term "substrate" has it usual meaning in materials science as an object comprising a surface on which processing is conducted. The substrate can be suitable for manufacturing electronics thereon, e.g. integrated circuitry. For example, the substrate comprises polyester. Processing may comprise fabrication of electronic structures on the substrate in one or more processing steps, e.g. printing of material such as silver paste to form conductive tracks, pick and place of the electronic component, usually with an electrically conductive adhesive or solder between the component and the tracks, deposition of other materials such as underfill between the electronic component and substrate. Also other steps may be used such as cutting openings in the substrate to improve flexibility and/or sealing or encapsulating the circuit to protect against external influences e.g. water or wear and tear. Further example steps may include layer deposition, exposure, curing, etcetera.

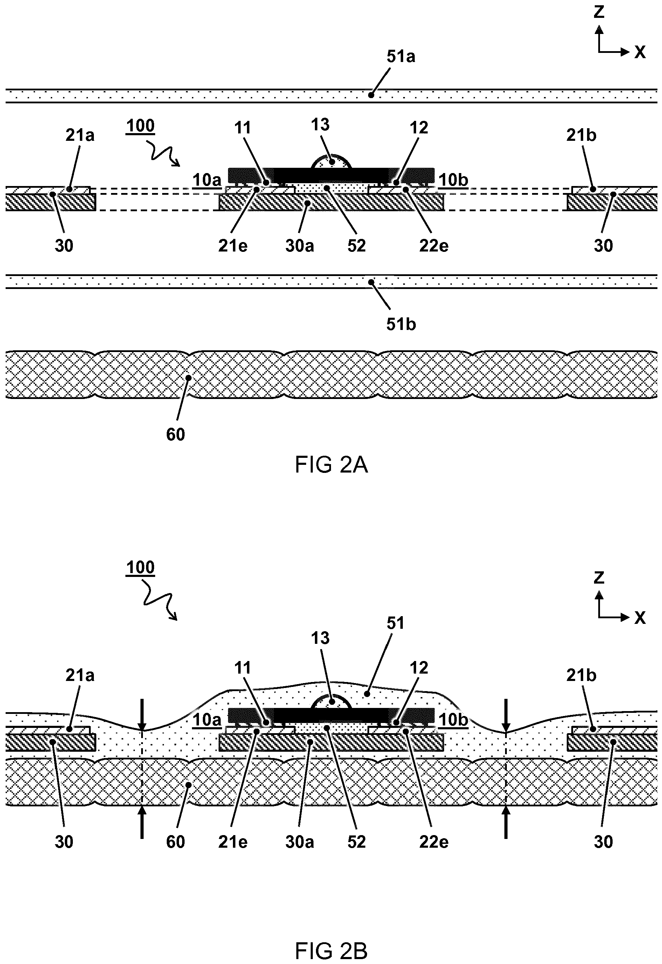

FIGs 2A and 2B schematically illustrate side views of steps for adhering the electronic circuit 100 to a fabric 60.

In one embodiment, the substrate 30 is a flexible foil. Typically, the electronic component 10 is relatively rigid compared to the substrate 30. In some embodiments, the conductive tracks 20 are deposited, e.g. printed on the substrate 30. For example the conductive tracks 20 comprise a printable and/or flexible material such as silver paste. In some embodiments, a volume between the electronic component 10 and a part of the substrate 30a below the electronic component 10 and between the contact pads 21,22 and/or between the first electrical contacts 11,12 is filled by underfill material 52. This may improve robustness.

In one embodiment, the circuit 100, or at least the electronic component 10 of the electronic circuit 100 is encapsulated by a protective layer 51 that protect the electronic circuit 100 from e.g. from water and/or wear and tear. For example, the protective layer 51 is such that the electronic circuit 100 continues to function during or after it is submerged in water. In one embodiment, the protective layer 51 comprises a top layer 51a and a bottom layer 51b encapsulating the electronic circuit 100 from either side. For example, the protective layer 51 comprises thermoplastic polyurethane (TPU).

In one embodiment, the protective layer 51, e.g. thermoplastic material is partially melted or at least softened to form an integrated encapsulated material. Simultaneously, or sequentially, the circuit may be adhered to another layer, e.g. fabric layer 60. In some embodiments, fabric layers may be applied from both sides of the circuit, e.g. the circuit is integrated between two clothing layers. In other or further embodiments, a hole may be formed in one of the clothing layers to transmit light from a light source 13. Preferably, the protective layer 51 is thus transparent to said light.

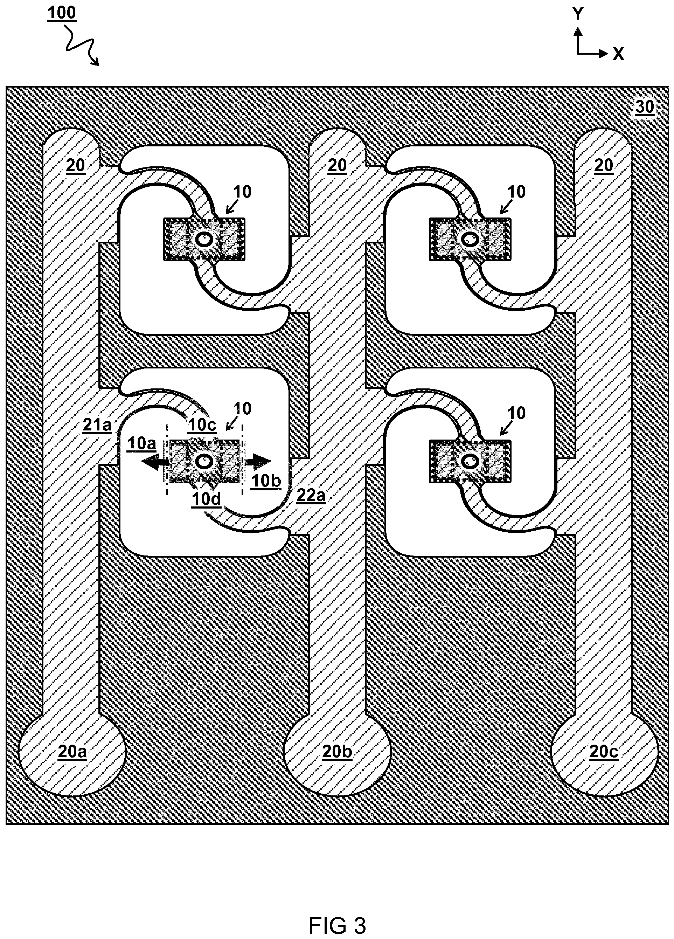

FIG 3 schematically illustrates a plan view of an embodiment of a flexible electronic circuit 100 or assembly comprising multiple electronic components 10. In one embodiment, the electronic circuit 100 comprises multiple electronic components 10, each connected to the conductive tracks 20 as described herein. For example, the conductive tracks 20 comprise external contact points 20a,20b,20c for electronically addressing one or more of the electronic components 10. The circuit with multiple components may e.g. find application in clothing or otherwise.

As illustrated in this figure, the sides 10a and 10b where the main connections 21a and 21b are located, may refer to a general direction away from a respective face of the component 10 where its electrical contacts are situated. The sides 10c, 10d are the transverse sides which may be defined by the intersecting centerline dividing the contacts (not shown).

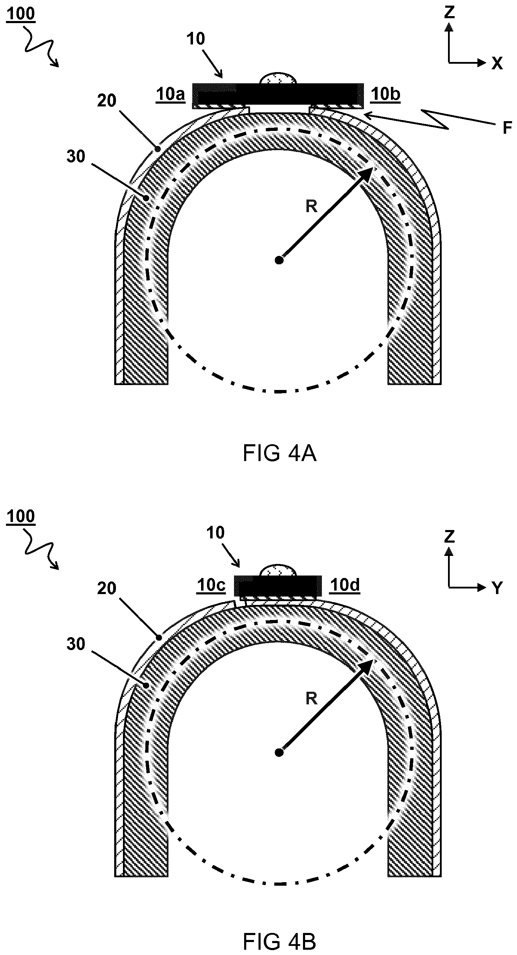

FIGs 4A and 4B show a comparison of placing the electronic component 10 onto the substrate 30, either with its short sides 10a,10b facing the conductive tracks 20, or its long sides 10c,10d facing the conductive tracks 20.

It will be appreciated that the electronic circuit 100 depicted in FIG 4B may have improved tolerance for bending compared to FIG 4A due to the component 10 being rotated such that the conductive tracks 20 connect from the longer sides 10c,10d of the component instead of the shorted sides 10a,10b. It can be observed that the configuration of FIG 4A may exhibit failure "F" at a particular radius of curvature "R", e.g. due to the relatively rigid electronic component 10 peeling away from the relatively flexible substrate 30 with conductive tracks 20 when it is bent. On the other hand it can be observed that the preferred configuration of FIG 4B may remain functional at the same radius of curvature "R" because the relatively rigid component 10 is now arranged with it longer side along the fold transverse to the conductive tracks 20.

In the production of flexible electronics, the substrate typically comprises a foil. The term "foil" refers to a sheet comprising one or more layers of material. Preferably, the foil is flexible such that it can be used in a roll-to-roll (R2R) or roll to sheet (R2S) manufacturing process. Furthermore, for some purposes it is desired that the flexible electronic circuit can be integrated in a product such as clothing fabric with minimal impact on the flexibility of the product. In some embodiments,, a substrate 30 (e.g. foil) may be considered flexible if it has a relatively low flexural rigidity, e.g. less than 500 Pa·m³, less than 100 Pa·m³, or even less than 10 Pa·m³. In other or further embodiments, an electronic circuit 100 may be considered flexible if the substrate 30 can be rolled or bent over a radius of curvature "R" less than five centimeters, e.g. less than three, two, one, or even less than half a centimeter, without the circuit losing essential electronic functionality. For example, the electronic component 10 remains functional and electrically attached to the conductive tracks 20 during or after the electronic circuit is bent.

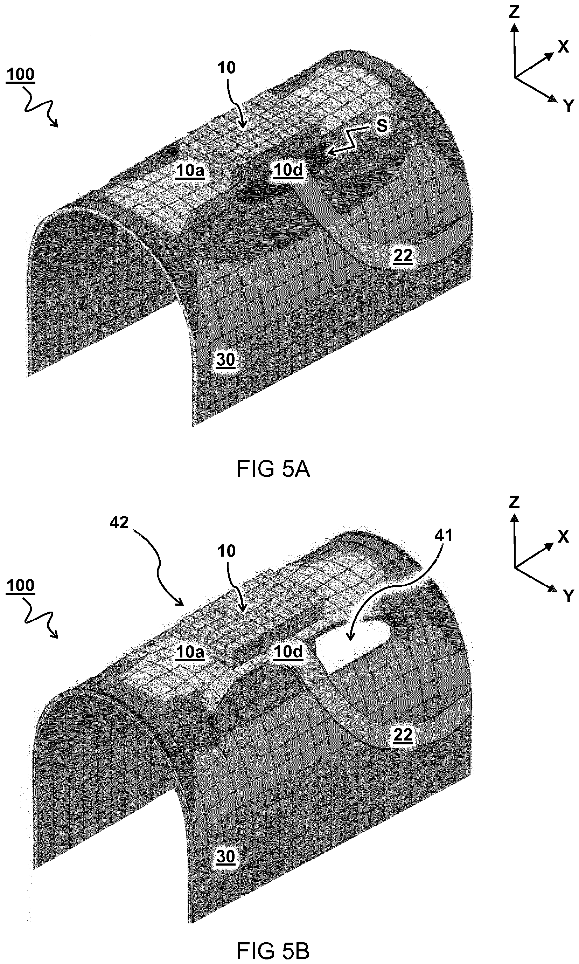

FIGs 5A and 5B shows perspective views of a comparative study with simulations of stress forces in a substrate without and with incisions 41, 42 (not visible), respectively. The higher stresses are indicated by darker shading. For example, on the one hand it may be observed in FIG 5A that a relatively large stress force S is localized adjacent the rigid component 10 at a side 10d where the conductive track 22 (added for illustration) approaches the component. On the other hand, it will be appreciated that the incision 41 may alleviates the stress in the adjacent area to possibly prevent electronic failure of the electronic circuit 100.

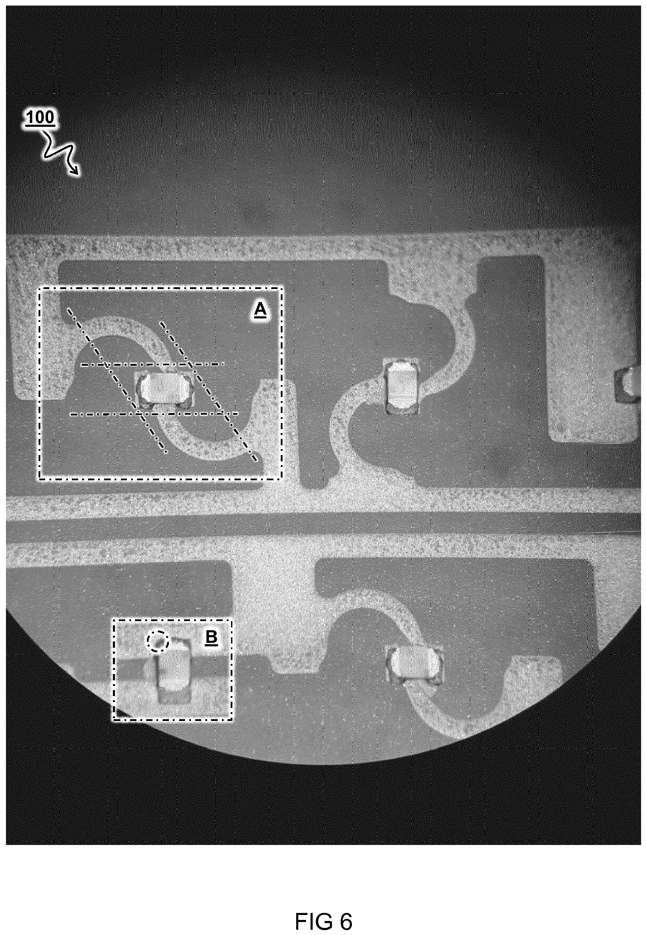

FIG 6 shows an enlarged photograph of an embodiment of the electronic circuit 100 comprising multiple components. For example, the component at the inset "A" is connected with swirling conductive tracks starting at the center line through the longer sides of the component between the electrical contacts. As illustrated by dash-dotted lines, it is preferred in some embodiments that the conducting curved sections around the component are such that folding lines transverse to the curved path do not intersect the component. Comparing with the more traditional connection of inset "B", it is indicated by the circle that connection "B" has conductive tracks at the corners of the component, while this is avoided in the advantageous connection "A"

General advantages of these or other embodiments may include some aspects wherein stress can be directed to less vulnerable regions possibly in combination with a lowering of the experienced stress at the regions by a structuring of the substrate and a design in the electronics. For example, the more flexible substrate/conductive tracks, need not connect the component, e.g. LED, from the outer edge (short sides), but from the middle (long sides). Bending at the edge of the LED, may jeopardize the interconnect by 'peeling off the substrate from the LED. When the substrate is locally removed, this is alleviated. The long side of the LED is also less vulnerable than the short side as the flexible device may typically handle a smaller bending radius in this direction (perpendicular to the long side).

Further advantages may be achieved by the combination of conductive track design to access the component at/from the most favorable side/direction (possibly deviating from the most logical site when contact pads are considered) and changing the mechanical properties locally around the interconnect/contact pads. The adjustment of mechanical properties can be achieved by incisions, perforations, thickening or thinning of materials or otherwise lowering Young's modules of materials structures.

Optimization according to some embodiments may include access of conductive structures to interconnect the component in combination with creation of optimal stress release around the most critical edges of the component. For example, the conductive track may be displaced to the sides of the component where there is in principal no contact. By excision of substrate around meander shaped tracks an enhanced mobility may be achieved. For example, incisions may displace the critical regions from next to the component to the external edge on the component thereby safeguarding the electrical connection.

For the purpose of clarity and a concise description, features are described herein as part of the same or separate embodiments, however, it will be appreciated that the scope of the invention may include embodiments having combinations of all or some of the features described. Of course, it is to be appreciated that any one of the above embodiments or processes may be combined with one or more other embodiments or processes to provide even further improvements in finding and matching designs and advantages. It is appreciated that this disclosure offers particular advantages to wearable electronics, and in general can be suitable for any application of a flexible electronic circuit.

While the present systems and methods have been described in particular detail with reference to specific exemplary embodiments thereof, it should also be appreciated that numerous modifications and alternative embodiments may be devised by those having ordinary skill in the art without departing from the scope of the present disclosure. For example, embodiments wherein devices or systems are disclosed to be arranged and/or constructed for performing a specified method or function inherently disclose the method or function as such and/or in combination with other disclosed embodiments of methods or systems. Furthermore, embodiments of methods are considered to inherently disclose their implementation in respective hardware, where possible, in combination with other disclosed embodiments of methods or systems. Furthermore, methods that can be embodied as program instructions, e.g. on a non-transient computer-readable storage medium, are considered inherently disclosed as such embodiment.

Finally, the above-discussion is intended to be merely illustrative of the present systems and/or methods and should not be construed as limiting the appended claims to any particular embodiment or group of embodiments. The specification and drawings are accordingly to be regarded in an illustrative manner and are not intended to limit the scope of the appended claims. In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. The mere fact that certain measures are recited in mutually different claims does not indicate that a combination of these measures cannot be used to advantage. In particular, all working combinations of the claims are considered inherently disclosed.

## Claims

1. A flexible electronic circuit (100) comprising
- a substrate (30);
- an electronic component (10) comprising
o a first electrical contact (11) on a first side (10a) of the electronic component (10), and
o a second electrical contact (12) on a second side (10b) of the electronic component (10) opposite the first side (10a); and
- conductive tracks (20) disposed on the substrate (30); wherein the conductive tracks (20) comprise
o a first conductive track (21) formed along a first pathway (21a-e) between a first contact pad (21e) contacting one of the electrical contacts (11,12) of the electronic component (10) and a first main connection (21a) to the rest of the conductive tracks (20) disposed at the first side (10a) of the electronic component (10), and
o a second conductive track (22) formed along a second pathway (22a-e) between a second contact pad (22e) contacting the other one of the electrical contacts (11,12) of the electronic component (10) and a second main connection (22a) to the rest of the conductive tracks (20) disposed at the second side (10b) of the electronic component (10);
**wherein**
- the first pathway (21a-e) comprises a first arced section (21c) that approaches the electronic component (10) from a third side (10c) along a center line (CL) of the electronic component (10), which center line (CL) intersects the electronic component (10) at the third side (10c) of the electronic component (10) transverse to the first side (10a) and the second side (10b) of the electronic component (10) and between the electrical contacts (11,12); and
- the second pathway (22a-e) comprises a second arced section (22c) that approaches the electronic component (10) along the center line (CL) of the electronic component (10) from a fourth side (10d) of the electronic component (10) opposite the third side (10c).

2. The flexible electronic circuit (100) according to claim 1, wherein the arced sections (21c,22c) respectively extend over a semicircular or semielliptical path between the electrical contact (11,12) of the electronic component (10) and the main connection (21a,22a) to the electronic circuit (100), wherein the direction along a respective arced section (21c,22c) along an arc length corresponding to a change of angle (θ1,θ2) of more than ninety degrees.

3. The flexible electronic circuit (100) according to claim 1 or 2, wherein the arced sections (21c,22c) swirl at least partially around the electronic component (10).

4. The flexible electronic circuit (100) according to any of the preceding claims, wherein a shape of the first arced section (21c) is rotation symmetric to a shape of the second arced section (22c).

5. The flexible electronic circuit (100) according to any of the preceding claims, wherein the first conductive track (21) starting from the first main connection (21a) disposed at the first side (10a) of the electronic component (10) connects to the second electrical contact (12) disposed at the second side (10b) opposite the first side (10a).

6. The flexible electronic circuit (100) according to any of the preceding claims, wherein the first arced section (21c) of the first conductive track (21) approaching the electronic component (10) from the third side (10c) transitions into a first buried section (21d) that starts from the center line (CL) and proceeds between the electronic component (10) and a part (30a) of the substrate (30) below the electronic component (10) to connect to the first contact pad (21e) from a direction of the center line (CL).

7. The flexible electronic circuit (100) according to any of the preceding claims, wherein a minimum track width (W1a,W2a) of the respective main connection (21a,22a) to which the arced sections 21c,22c connect is wider than a minimum track width (W1c,W2c) of the respective arced section (21c,22c) by at least a factor two.

8. The flexible electronic circuit (100) according to any of the preceding claims, wherein the arced sections (21c,22c) are connected to the respective main connections (21a,22a) by respective a tear drop sections (21b,22b) that widen from the respective arced section (21c,22c) towards the respective main connection (21a,22a).

9. The flexible electronic circuit (100) according to any of the preceding claims, wherein the electronic component (10) has a length (L) that is greater along a first direction (X) in plane of the substrate (30) than its width (W) along a second direction (Y), transverse to the first direction (X) in plane of the substrate (30), wherein the second direction (Y) is aligned with the center line (CL) through the third side (10c) and fourth side (10d) of the electronic component (10) such that the first and second conductive tracks approach the electronic component (10) from its relatively longer third and fourth sides (10c,10d).

10. The flexible electronic circuit (100) according to any of the preceding claims, wherein the substrate (30) is excised to form openings (41,42) without the substrate at least around each of the arced sections (21c,22c), wherein the openings (41,42) are close to the outer edges of the arced sections (21c,22c), e.g. with a margin of substrate without conducting track being less than fifty percent of the respective track width (W1c,W2c) of the arced section.

11. The flexible electronic circuit (100) according to any of the preceding claims, wherein at least the electronic component (10) of the electronic circuit (100) is encapsulated by a protective layer (51).

12. The flexible electronic circuit (100) according to any of the preceding claims, wherein the conductive tracks (20) are printed on the substrate (30).

13. An article of clothing comprising the flexible electronic circuit (100) according to any of the preceding claims.

14. A method of manufacturing a flexible electronic circuit (100) comprising
- providing a substrate (30);
- depositing conductive tracks (20) onto the substrate (30); and
- placing an electronic component (10) onto the conductive tracks (20);
wherein the electronic component (10) comprises
o a first electrical contact (11) on a first side (10a) of the electronic component (10), and
o a second electrical contact (12) on a second side (10b) of the electronic component (10) opposite the first side (10a); and
wherein the conductive tracks (20) comprise
o a first conductive track (21) formed along a first pathway (21a-e) between a first contact pad (21e) contacting one of the electrical contacts (11,12) of the electronic component (10) and a first main connection (21a) to the rest of the conductive tracks (20) disposed at the first side (10a) of the electronic component (10), and
o a second conductive track (22) formed along a second pathway (22a-e) between a second contact pad (22e) contacting the other one of the electrical contacts (11,12) of the electronic component (10) and a second main connection (22a) to the rest of the conductive tracks (20) disposed at the second side (10b) of the electronic component (10); **wherein**
- the first pathway (21a-e) comprises a first arced section (21c) that approaches the electronic component (10) from a third side (10c) along a center line (CL) of the electronic component (10), which center line (CL) intersects the electronic component (10) at the third side (10c) of the electronic component (10) transverse to the first side (10a) and the second side (10b) of the electronic component (10) and between the electrical contacts (11,12); and
- the second pathway (22a-e) comprises a second arced section (22c) that approaches the electronic component (10) along the center line (CL) of the electronic component (10) from a fourth side (10d) of the electronic component (10) opposite the third side (10c).

15. The method according to claim 14, wherein the method further comprises cutting openings (41,42) in the substrate (30) to disconnect the arced sections (21c,22c) of the conductive tracks (20) from the surrounding substrate (3), wherein the electronic component (10) is substantially only connected to the surrounding substrate (30) via the conductive tracks of the arced sections (21c,22c).
